# EUROPÄISCHE PATENTSCHRIFT

(11) **EP 0 544 107 B1**
(45) Veröffentlichungstag und Bekanntmachung des Hinweises auf die Patenterteilung: **29.11.1995**
(21) Anmeldenummer: 92118238.2
(22) Anmeldetag: 24.10.1992
(51) Int. Cl.: H01J 37/34

(54) **Verfahren und Vorrichtung zum Beschichten eines Substrats, insbesondere mit elektrisch nichtleitenden Schichten**
Method and apparatus for coating a substrate, in particular for electrical insulating layers
Procédé et appareil pour revêtir un substrat, notamment pour des couches en matériau électriquement non-conducteur

(30) Priorität: 26.11.1991 DE 4138793; 19.02.1992 DE 4204999
(43) Veröffentlichungstag der Anmeldung: 02.06.1993
(73) Patentinhaber: Balzers und Leybold Deutschland Holding Aktiengesellschaft, 63450 Hanau (DE)
(72) Erfinder: Bräuer, Günter, Dr., W-6463 Freigericht 1 (DE); Szczyrbowski, Joachim, Dr., W-8758 Goldbach (DE); Teschner, Götz, Dipl.-Ing., W-6460 Gelnhausen (DE)

(56) Entgegenhaltungen:
- DD-A- 221 202
- DD-A- 252 205
- DE-B- 1 025 234
- DE-B- 1 068 972
- US-A- 5 082 546

## Beschreibung

Die Erfindung betrifft eine Vorrichtung zum Beschichten eines Substrats, insbesondere mit elektrisch nichtleitenden Schichten, von elektrisch leitfähigen Targets in reaktiver (z. B. oxidierender) Atmosphäre, mit einer Stromquelle, die mit in einer evakuierbaren Beschichtungskammer angeordneten, Magnete einschließenden Kathoden verbunden ist, die elektrisch mit den Targets zusammenwirken, die Zerstäubt werden und deren abgestäubte Teilchen sich auf dem Substrat niederschlagen, wobei elektrisch voneinander und von der Sputterkammer getrennte Anoden angeordnet sind, die in einer Ebene zwischen den Kathoden und dem Substrat vorgesehen sind.

Es ist bereits eine Zerstäubungseinrichtung zur Herstellung dünner Schichten bekannt (DD 252 205), bestehend aus einem Magnetsystem und mindestens zwei darüber angeordneten Elektroden aus dem zu zerstäubenden Material, wobei diese Elektroden elektrisch so gestaltet sind, daß sie wechselweise Kathode und Anode einer Gasentladung sind. Die Elektroden sind zu diesem Zwecke an eine sinusförmige Wechselspannung von vorzugweise 50 Hz angeschlossen.

Diese bekannte Zerstäubungseinrichtung soll besonders für die Abscheidung dielektrischer Schichten durch reaktive Zerstäubung geeignet sein. Durch den Betrieb der Einrichtung mit etwa 50 Hz soll vermieden werden, daß es zur Flitterbildung an der Anode und im Falle von Metallbeschichtung zu elektrischen Kurzschlüssen (sogenannten arcs) kommt.

Bei einer anderen bereits bekannten Vorrichtung zum Aufstäuben eines dünnen Films, bei der die Geschwindigkeit des Niederbringens von Schichten unterschiedlicher Materialien regelbar ist (DE 39 12 572), um so zu extrem dünnen Schichtpaketen zu gelangen, sind mindestens zwei unterschiedliche Arten von kathodenseitig vorgesehenen Gegenelektroden angeordnet.

Weiterhin ist eine Anordnung zum Abscheiden einer Metalllegierung mit Hilfe von HF-Kathodenzerstäubung bekannt (DE 35 41 621), bei der abwechselnd zwei Targets angesteuert werden, wobei die Targets die Metallkomponenten der abzuscheidenden Metallegierung jedoch mit unterschiedlichen Anteilen enthalten. Die Substrate sind zu diesem Zweck auf einem Substratträger angeordnet, der von einer Antriebseinheit während des Zerstäubungsvorgangs in Rotation versetzt wird.

Durch eine vorveröffentlichte Druckschrift (DE 38 02 852) ist es außerdem bekannt, bei einer Einrichtung für die Beschichtung eines Substrats mit zwei Elektroden und wenigstens einem zu zerstäubenden Material das zu beschichtende Substrat zwischen den beiden Elektroden in einem räumlichen Abstand anzuordnen und die Wechselstrom-Halbwellen als niederfrequente Halbwellen mit im wesentlichen gleichen Amplituden zu wählen.

Gemäß einer anderen vorveröffentlichten Druckschrift (DE 22 43 708) ist ein Verfahren zur Erzeugung einer Glimmentladung bekannt mit einer in einem Arbeitsgas angebrachten Elektrodenanordnung, an die eine Betriebsspannung angelegt wird, wobei das Verfahren durch die Erzeugung eines Magnetfeldes, das zusammen mit der Elektrodenanordnung mindestens eine Falle zum Festhalten praktisch aller von der Elektrodenanordnung emittierten Elektronen ergibt, die eine zur Ionisierung des Arbeitsgases ausreichende Energie haben. Für dieses Verfahren findet eine Elektrodenanordnung Verwendung, bei der die Elektroden paarweise vorgesehen sind. Insbesondere beschreibt diese Druckschrift auch Hohlelektroden, in deren Innerem eine Glimmentladung erzeugbar ist, wobei die Elektroden als Rohrschalen ausgebildet sind.

Weiterhin sind ein Verfahren und eine Vorrichtung in einer älteren, nicht vorveröffentlichten Patentanmeldung beschrieben (DE-A 41 06 770.3) zum reaktiven Beschichten eines Substrats mit einem elektrisch isolierenden Werkstoff, beispielsweise mit Siliziumdioxid (SiO₂), bestehend aus einer Wechselstromquelle, die mit in einer Beschichtungskammer angeordneten Magnete einschließenden Kathoden verbunden ist, die mit Targets zusammenwirken, wobei zwei erdfreie Ausgänge der Wechselstromquelle mit je einer ein Target tragenden Kathode verbunden sind, wobei beide Kathoden in der Beschichtungskammer nebeneinanderliegend in einem Plasmaraum vorgesehen sind und zum gegenüberliegenden Substrat jeweils etwa den gleichen räumlichen Abstand aufweisen. Der Effektivwert der Entladespannung wird dabei von einer über eine Leitung an die Kathode angeschlossenen Spannungseffektivwerterfassung gemessen und als Gleichspannung einem Regler über eine Leitung zugeführt, der über ein Regelventil den Reaktivgasfluß vom Behälter in die Verteilerleitung so steuert, daß die gemessene Spannung mit einer Sollspannung übereinstimmt.

Schließlich ist eine Vorrichtung zum reaktiven Beschichten eines Substrats in einer älteren, nicht vorveröffentlichten Patentanmeldung beschrieben (DE-A 41 36 655.7; Zusatz zu DE-A 40 42 289.5), bei der eine elektrisch von der Vakuumkammer getrennte, als Magnetron kathode ausgebildete, aus zwei elektrisch voneinander getrennten Teilen bestehende Kathode, bei der der Targetgrundkörper mit Joch und Magneten als der eine Teil - unter Zwischenschaltung einer Kapazität - an den negativen Pol einer Gleichstrom-Spannungsversorgung und das Target als der andere Teil über eine Leitung und unter Zwischenschaltung einer Drossel und einem dieser parallel liegenden Widerstand an die Stromversorgung angeschlossen ist und wobei das Target über eine weitere Kapazität mit dem Pluspol der Stromversorgung und mit der Anode verbunden ist, die ihrerseits - unter Zwischenschaltung eines Widerstands - auf Masse liegt, wobei in Reihe zur induktionsarmen Kapazität eine Induktivität in die Zweigleitung zum Widerstand und zur Drossel eingeschaltet ist und der Wert für den Widerstand typischerweise zwischen 2 KΩ und 10 KΩ liegt.

Diese Vorrichtung ist bereits so ausgebildet, daß sie die überwiegende Zahl der während eines Beschichtungsprozesses auftretenden Arcs unterdrückt und die Energie der Arcs absenkt und die Wiederzündung des Plasmas nach einem Arc verbessert.

Der vorliegenden Erfindung liegt nun die Aufgabe zugrunde, die während des Beschichtungsprozesses mittels Magnetronsputterquelle in reaktiver Atmosphäre auftretenden Arcs möglichst völlig zum Verschwinden zu bringen bzw. bereits in einer Phase des Prozesses, in der die Neigung zur Bildung eines Arcs zunimmt, diese Neigung zu erkennen und ihr entgegenzuwirken. Diese Stabilisierung des Sputterprozesses soll darüber hinaus besonders unempfindlich gegenüber Wasserdampfresten im Rezipienten sein.

Insbesondere soll das Verhalten der Vorrichtung gegenüber der Neigung, Arcs zu bilden, für solche Verfahren verbessert werden, die geeignet sind zur Beschichtung von Glasscheiben von metallisch leitfähigen Targets in reaktiver (z. B. oxidierender) Atmosphäre nichtleitende Schichten abzuscheiden. Schließlich soll die Vorrichtung so gestaltet sein, daß die Besonderheiten von Anlagen besonderer Größe keinen negativen Effekt auf die Stabilität des Verfahrens und die Zuverlässigkeit und Leistungsfähigkeit der Vorrichtung haben können.

Diese Aufgabe wird gemäß der Erfindung durch eine Vorrichtung gemäß Anspruch 1 gelöst. Gemäß der Erfindung ist die Mittelfrequenzspannung so niedrig bemessen, daß die Plasmaentladung bei jedem Nulldurchgang der Wechselspannung verlischt und in jeder Halbwelle der Wechselspannung erneut zündet, wenn die Spannung des Transformators ausreichend angestiegen ist, wozu die beiden Ausgänge der Sekundärwicklung des mit einem Mittelfrequenzgenerator verbundenen Transformators jeweils an eine Kathode über Versorgungsleitungen angeschlossen sind, die über eine Zweigleitung untereinander verbunden sind, in die ein Schwingkreis, vorzugsweise eine Spule und ein Kondensator eingeschaltet sind, wobei jede der beiden Versorgungsleitungen jeweils sowohl über ein das Gleichspannungspotential gegenüber Erde einstellendes erstes Netzwerk mit der Beschichtungskammer als auch über ein entsprechendes zweites Netzwerk mit der jeweiligen Anode verbunden ist.

Gemäß der Erfindung kommt es also darauf an, die Kathoden "weich" zu zünden, was mit Hilfe einer Drossel geschehen kann, die zwischen dem Transformator und dem Mittelfrequenzgenerator eingeschaltet ist. Weiterhin ist eine Umschwinganordnung zwischen den Kathoden vorgesehen, die durch einen Arc zum Schwingen angeregt werden kann und die den Arc beim Umschwingen löscht. Die Eigenresonanz des Schwingkreises muß dabei ein Vielfaches der Arbeitsfrequenz der Anordnung sein.

Die Erfindung läßt die verschiedensten Ausführungsmöglichkeiten zu; zwei davon sind in den anliegenden Zeichnungen, die die Schaltschemata zweier Vorrichtungen zeigen, schematisch näher dargestellt.

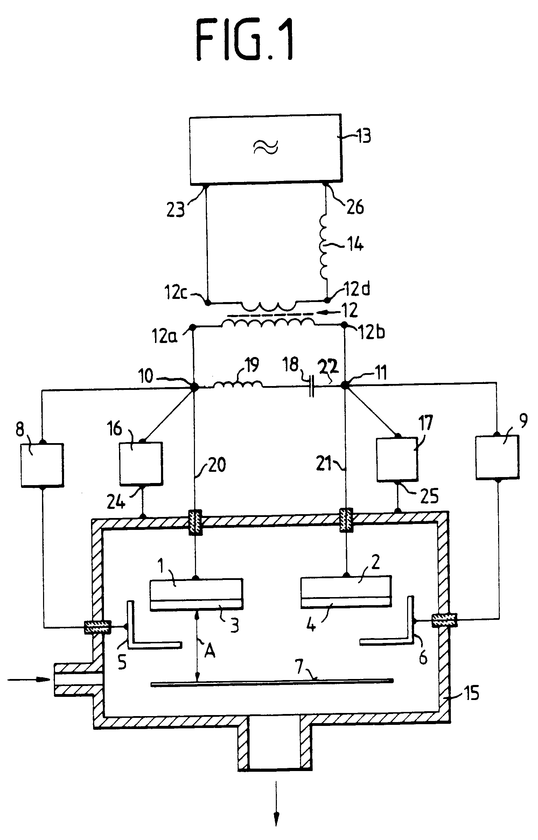

Gemäß Figur 1 werden in der Beschichtungskammer 15 zwei Kathoden 1, 2 von dem Mittelfrequenzgenerator 13 mit sinusförmigem Wechselstrom der Frequenz von 40 kHz so gespeist, daß die Kathoden abwechselnd den Minus- und den Pluspol der Sputterentladung darstellen.

In der Beschichtungskammer 15 sind die beiden Magnetronkathoden 1, 2 so benachbart angeordnet, daß zwischen den beiden Kathoden ein Plasma gezündet werden kann. Dabei werden die Kathoden so orientiert, daß die Oberflächen der auf den Kathoden angeordneten Targets 3, 4 in einer Ebene und parallel zur Ebene des Substrats 7 liegen oder unter einem Winkel zueinander und zur Substratebene angeordnet sind.

Zwischen den Targets 3, 4 und der Substratebene ist ein Abstand A eingehalten. In diesem Zwischenraum sind die Elektroden 5, 6 angeordnet, die über die elektrischen Netzwerke 8 und 9 mit den Kathoden 1 bzw. 2 in den Punkten 10 bzw. 11 verbunden sind.

In den Verbindungspunkten 10 bzw. 11 der Versorgungsleitungen 20, 21 sind die Kathoden 1 bzw. 2 außerdem mit jeweils einem Anschluß 12a, 12b der Sekundärwicklung des Transformators 12 verbunden. Dieser Transformator 12 erhält seine Energie aus dem Mittelfrequenzgenerator 13, in dem eine Ausgangsklemme 26 dieses Mittelfrequenzgenerators 13 mit einem Anschluß der Drosselspule 14, die andere Ausgangsklemme 23 des Mittelfrequenzgenerators 13 mit einem Anschluß 12c der Primärwicklung des Transformators 12 und der andere Anschluß 12d der Primärwicklung des Transformators 12 mit dem zweiten Anschluß der Drosselspule 14 verbunden sind.

Die Verbindungspunkte 10 bzw. 11 sind außerdem noch an die Netzwerke 16 bzw. 17 angeschlossen. Der jeweils zweite Anschluß 24, 25 der Netzwerke 16, 17 ist mit der Beschichtungskammer 15 verbunden. An den Verknüpfungspunkt 10 ist der eine Anschluß einer Spule 19 angeschlossen, deren zweiter Anschluß mit einem Anschluß des Kondensators 18 verbunden ist. Der zweite Anschluß des Kondensators ist mit Verknüpfungspunkt 11 über die Zweigleitung 22 verbunden.

Die Netzwerke 8, 9 und 16, 17 bestehen aus Reihenschaltungen von Dioden, Widerständen und Kondensatoren und stellen insgesamt das Gleichspannungspotential gegenüber der Erde (Masse) ein.

In der vorstehend beschriebenen Anordnung erzeugt der Mittelfrequenzgenerator 13 eine sinusförmige Wechselspannung, die mit dem Transformator 12 so hochgespannt wird, daß der Spannungsbereich an die Arbeitsspannung der Magnetronkathode 1, 2 angepaßt ist. Die beschriebene Schaltung Kathode 1, Transformator 12 zu Kathode 2 impliziert, daß zwischen den beiden Kathoden eine galvanische Verbindung besteht, in die über den Transformator 12 die Wechselspannung induziert wird. Durch diese Maßnahme wird erreicht, daß zu einem Zeitpunkt die Kathode 1 den Minuspol, d. h. den sputternden Teil der Entladung, und Kathode 2 den Pluspol der Entladung bilden. Zu einem anderen Zeitpunkt bildet die Kathode 1 den Pluspol der Entladung, und Kathode 2 ist der Minuspol und sputtert damit.

Die Frequenz der Mittelfrequenzspannung wird so niedrig gewählt, daß die Plasmaentladung bei jedem Nulldurchgang der Wechselspannung verlischt. Sie zündet in jeder Halbwelle der Wechselspannung neu, sobald die Spannung am Transformator 12 genügend angestiegen ist.

Dieses Wechselspiel sorgt dafür, daß die Entladung immer eine durch das Absputtern blanke Oberfläche als Pluspol findet. Wenn die eine Kathode als Pluspol dient, wird sie von der anderen in diesem Moment sputternden Kathode mit nichtleitenden Schichten belegt. Die Wechselfrequenz muß nun so hoch gewählt werden, daß die Belegung unwesentlich für den Prozeß bleibt.

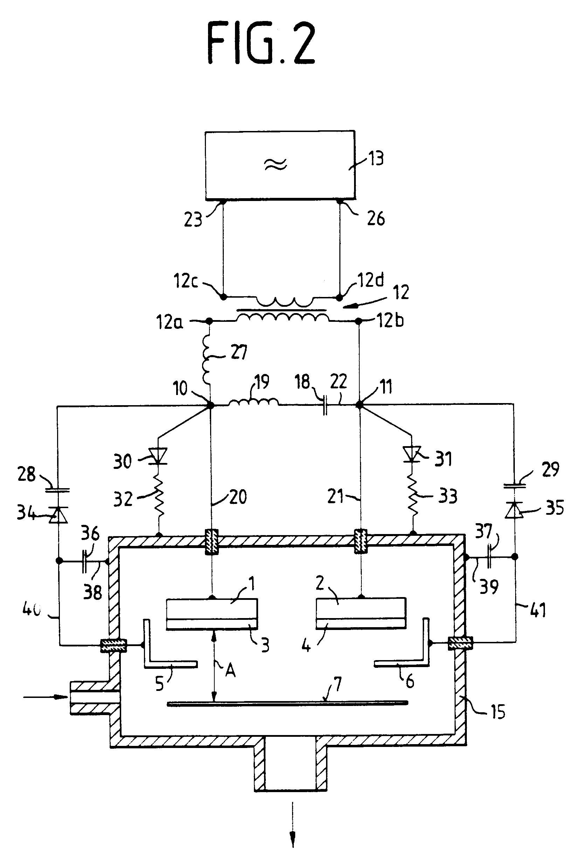

Da der physikalische Mechanismus identisch zum Gleichspannungssputtern ist, treten natürlich auch Arcs auf. Aber die Entstehung eines Arcs ist neben den Bedingungen an der Targetoberfläche auch an Zeit, Strom- und Potentialbedingungen geknüpft (wählt man die Wechselfrequenz so hoch, daß die Polarität schon wieder wechselt, bevor sich der Arc ausbilden konnte). Die Drossel 14 bewirkt eine Verzögerung im Stromanstieg sowohl beim Zünden als auch bei der Ausbildung der Arcs. Der aus der Spule 19 und dem Kondensator 18 gebildete Schwingkreis ist auf eine Frequenz eingestellt, die wesentlich höher ist als die Arbeitsfrequenz - etwa das 50fache. Sollte sich ein Arc ausbilden, schwingt dieser Schwingkreis an und verursacht einen zusätzlichen Wechsel in der Polarität der Kathoden, so daß der Arc sofort verschwindet. Die Netzwerke 8, 9 bzw. 16, 17 sorgen dafür, daß die Potentiale der Elektroden 5, 6 und der Beschichtungskammer 15 so gehalten werden, daß geringe Feldstärken in der Kammer 15 auftreten und damit die Arc-Bildung ebenfalls verzögern.
Die praktische Arc-Freiheit wird nun durch die Kombination dieser Maßnahmen erreicht: 2 galvanisch verbundene Kathoden, Frequenz, Drossel, Netzwerke für Potentialeinstellung.
o Für die Arbeitsfrequenz wurde ein Optimum bei 40 kHz gefunden. Die Anwendung von Frequenzen abweichend von 40 kHz im Bereich von 8 kHz bis 70 kHz ist bei Hinnahme von Qualitätseinbußen denkbar.
o Statt einphasigem Wechselstrom kann eine Anordnung mit mehrphasigem (Drehstrom) Wechselstrom benutzt werden.
o Der Transformator 12 kann mit mehreren Sekundärwicklungen versehen werden, so daß mehrere Paare von Kathoden betrieben werden.
o Die Anordnung der Kathoden kann statt nebeneinander
   - ineinander geschachtelt,
   - dachförmig über dem Substrat,
   - gegenüberliegend mit durchbrochenem Substrat in der Mitte,
   - ähnlich einem Quadrupol räumlich verteilt sein.
o Die Konstruktionsform der verwendeten Kathoden kann neben dem Planarmagnetron auch
   - ein Zwischenpoltarget
   - ein Rohrmagnetron
   - ein Torusmagnetron
   sein.
   Auch bei dem Ausführungsbeispiel gemäß Figur 2 werden in der Beschichtungskammer 15 zwei Kathoden 1, 2 von dem Mittelfrequenzgenerator 13 mit sinusförmigem Wechselstrom der Frequenz von 40 kHz so gespeist, daß die Kathoden abwechselnd den Minus- und den Pluspol der Sputterentladung darstellen.
   Zwischen den Targets 3, 4 und der Substratebene ist ein Abstand A eingehalten. Im Zwischenraum A sind die Elektroden 5, 6 angeordnet, die über ein jeweils aus einem Kondensator 28 bzw. 29 und einer Diode 34 bzw. 35 bestehendes elektrisches Glied mit den Kathoden 1 bzw. 2 in den Punkten 10 bzw. 11 verbunden sind.
   In den Verbindungspunkten 10 bzw. 11 der Versorgungsleitungen 20, 21 sind die Kathoden 1 bzw. 2 außerdem mit jeweils einem Anschluß 12a, 12b der Sekundärwicklung des Transformators 12 verbunden, wobei in die Verbindungsleitung vom Punkt 10 zum Anschluß 12a noch eine Drosselspule 27 eingeschaltet ist. Dieser Transformator 12 erhält seine Energie aus dem Mittelfrequenzgenerator 13, in dem eine Ausgangsklemme 23 dieses Mittelfrequenzgenerators 13 mit einem Anschluß 12c der Primärwicklung des Transformators 12 und der andere Anschluß 12d der Primärwicklung des Transformators 12 mit dem zweiten Anschluß 26 des Generators 13 verbunden ist.
   Die Verbindungspunkte 10 bzw. 11 sind außerdem noch an die Dioden 30 bzw. 31 angeschlossen, denen jeweils noch ein Widerstand 32 bzw. 33 nachgeschaltet ist. Die Widerstände 32 bzw. 33 sind jeweils mit der Beschichtungskammer 15 verbunden. Anden Verknüpfungspunkt 10 ist der eine Anschluß einer Spule 19 angeschlossen, deren zweiter Anschluß mit einem Anschluß des Kondensators 18 verbunden ist. Der zweite Anschluß des Kondensators ist mit Verknüpfungspunkt 11 über die Zweigleitung 22 verbunden.
   Die jeweils aus einem Widerstand 32 bzw. 33 und einer Diode 30 bzw. 31 gebildeten elektrischen Glieder stellen insgesamt das Gleichspannungspotential gegenüber der Erde (Masse) ein. Es sei noch erwähnt, daß die elektrischen Glieder 28, 34 bzw. 29, 35 über Zweigleitungen 38, 39, in die jeweils Kondensatoren 36, 37 eingeschaltet sind, mit der Kammer 15 verbunden sind.
   In der Anordnung gemäß Figur 2 erzeugt der Mittelfrequenzgenerator 13 eine sinusförmige Wechselspannung, die mit dem Transformator 12 so hochgespannt wird, daß der Spannungsbereich an die Arbeitsspannung der Magnetronkathoden 1, 2 angepaßt ist. Die beschriebene Schaltung Kathode 1, Transformator 12 zu Kathode 2 impliziert, daß zwischen den beiden Kathoden eine galvanische Verbindung besteht, in die über den Transformator 12 die Wechselspannung induziert wird. Durch diese Maßnahme wird erreicht, daß zu einem Zeitpunkt die Kathode 1 den Minuspol, d. h. den sputternden Teil der Entladung, und Kathode 2 den Pluspol der Entladung bilden. Zu einem anderen Zeitpunkt bildet die Kathode 1 den Pluspol der Entladung, und Kathode 2 ist der Minuspol und sputtert damit.
   Die Frequenz der Mittelfrequenzspannung wird wiederum so niedrig gewählt, daß die Plasmaentladung bei jedem Nulldurchgang der Wechselspannung verlischt und in jeder Halbwelle der Wechselspannung neu zündet, sobald die Spannung am Transformator 12 genügend angestiegen ist.

Die Drossel 27 bewirkt eine Verzögerung im Stromanstieg sowohl beim Zünden als auch bei der Ausbildung der Arcs. Der aus der Spule 19 und dem Kondensator 18 gebildete Schwingkreis ist auf eine Frequenz eingestellt, die wesentlich höher ist als die Arbeitsfrequenz - etwa das 50fache. Sollte sich ein Arc ausbilden, schwingt dieser Schwingkreis an und verursacht einen zusätzlichen Wechsel in der Polarität der Kathoden, so daß der Arc sofort verschwindet. Die elektrischen Glieder 28, 34 bzw. 29, 35 sorgen dafür, daß die Potentiale der Elektroden 5, 6 und der Beschichtungskammer 15 so gehalten werden, daß geringe Feldstärken in der Kammer 15 auftreten und damit die Arc-Bildung ebenfalls verzögern. Die praktische Arc-Freiheit wird nun durch die Kombination folgender Maßnahmen erreicht: Zwei galvanisch verbundene Kathoden 1, 2, Schwingkreis 18, 19, Drossel 27, elektrische Glieder 28, 34 bzw. 29, 35 und 30, 32 bzw. 31, 33 für die Potentialeinstellung.
o Bei dieser Ausführungsform wurde für die Arbeitsfrequenz ein Optimum bei 40 kHz gefunden. Die Anwendung von Frequenzen abweichend von 40 kHz im Bereich von 8 kHz bis 70 kHz ist bei Hinnahme von Qualitätseinbußen möglich.
o Genau wie bei der Ausführungsform nach Figur 1 kann statt einphasigem Wechselstrom eine Anordnung mit mehrphasigem (Drehstrom) Wechselstrom benutzt werden.
o Auch die Anordnung der Kathoden kann statt nebeneinander
   - ineinander geschachtelt,
   - dachförmig über dem Substrat,
   - gegenüberliegend mit durchbrochenem Substrat in der Mitte,
   - ähnlich einem Quadrupol räumlich verteilt sein.
o Die Konstruktionsform der verwendeten Kathoden kann neben dem Planarmagnetron auch
   - ein Zwischenpoltarget
   - ein Rohrmagnetron
   - ein Torusmagnetron
   sein.

### Bezugszeichenliste

- 1: Kathode
- 2: Kathode
- 3: Target
- 4: Target
- 5: Anode, Elektrode
- 6: Anode, Elektrode
- 7: Substrat
- 8: elektrisches Netzwerk
- 9: elektrisches Netzwerk
- 10: Verbindungspunkt, Verknüpfungspunkt
- 11: Verbindungspunkt, Verknüpfungspunkt
- 12: Transformator
- 12a, 12b: Anschlußklemmen
- 12c, 12d: Anschlußklemmen
- 13: Mittelfrequenzgenerator
- 14: Drosselspule
- 15: Beschichtungskammer
- 16: Netzwerk
- 17: Netzwerk
- 18: Kondensator
- 19: Spule
- 20: Versorgungsleitung
- 21: Versorgungsleitung
- 22: Zweigleitung
- 23: Ausgangsklemme
- 24: Anschluß
- 25: Anschluß
- 26: Ausgangsklemme
- 27: Drosselspule
- 28: Kondensator
- 29: Kondensator
- 30: Diode
- 31: Diode
- 32: Widerstand
- 33: Widerstand
- 34: Diode
- 35: Diode
- 36: Kondensator
- 37: Kondensator
- 38: Zweigleitung
- 39: Zweigleitung
- 40: Verbindungsleitung
- 41: Verbindungsleitung

## Patentansprüche

1. Vorrichtung zum Beschichten eines Substrats (7), insbesondere mit nichtleitenden Schichten, von elektrisch leitfähigen Targets (3, 4) in reaktiver (z.B. oxidierender) Atmosphäre, mit einer Stromquelle (12, 13, 14, 27), die mit in einer evakuierbaren Beschichtungskammer (15) angeordneten, Magnete einschließenden Kathoden (1, 2) verbunden ist, die elektrisch mit den Targets (3, 4) zusammenwirken, die zerstäubt werden und deren abgestäubte Teilchen sich auf dem Substrat (7) niederschlagen, wobei elektrisch voneinander und von der Sputterkammer (15) getrennte Anoden (5, 6) angeordnet sind, die in einer Ebene zwischen den Kathoden (1, 2) und dem Substrat (7) vorgesehen sind, wobei die Stromquelle einen Mittelfrequenzgenerator (13), einen Transformator (12) und eine Drosselspule (14; 27) aufweist und die Mittelfrequenzspannung so niedrig gewählt ist, daß die Plasmaentladung bei jedem Nulldurchgang der Wechselspannung verlischt und in jeder Halbwelle der Wechselspannung neu zündet, sobald die Spannung des Transformators ausreichend angestiegen ist, wozu die Ausgänge (12a, 12b) der Sekundärwicklung mit einem Mittelfrequenzgenerator (13) verbundenen Transformators (12) jeweils über Versorgungsleitungen (20, 21) an eine der Kathoden (1 bzw. 2) angeschlossen sind, wobei die Versorgungsleitungen (20, 21) über eine Zweigleitung (22) untereinander verbunden sind, in die ein Schwingkreis eingeschaltet ist und wobei jede der beiden Versorgungsleitungen (20, 21) jeweils sowohl über ein das Gleichspannungspotential gegenüber Erde einstellendes erstes Netzwerk (16 bzw. 17) mit der Beschichtungskammer (15) als auch über ein entsprechendes zweites Netzwerk (8 bzw. 9) mit der jeweiligen Anode (5 bzw. 6) verbunden ist.

2. Vorrichtung nach Anspruch 1 **dadurch gekennzeichnet,** daß jede der beiden Versorgungsleitungen (20, 21) jeweils sowohl über ein das Gleichspannungspotential gegenüber Erde einstellendes erstes elektrisches Glied (30, 32 bzw. 31, 33) mit der Beschichtungskammer (15) als auch über ein entsprechendes zweites elektrisches Glied (28, 34 bzw. 29, 35) mit der jeweiligen Anode (5 bzw. 6) und über jeweils eine Zweigleitung (38 bzw. 39) mit eingeschaltetem Kondensator (36 bzw. 37) mit der Beschichtungskammer (15) verbunden ist und wobei eine Drosselspule (27) in die den Schwingkreis (18, 19) mit dem Sekundäranschluß (12a) des Transformators verbindenden Abschnitt der ersten Versorgungsleitung (20) eingeschaltet ist.

3. Vorrichtung nach Anspruch 2, **dadurch gekennzeichnet,** daß die in die beiden Zweigleitungen, die die Versorgungsleitungen (20, 21) mit der Beschichtungskammer (15) verbinden, eingeschalteten ersten elektrischen Glieder jeweils aus einem Widerstand (32 bzw. 33) und einer Diode (30 bzw. 31) gebildet sind, wobei in die die Versorgungsleitung (20 bzw. 21) mit der Anode (5 bzw. 6) verbindenden Zweigleitungen (40, 41) jeweils ein zweites elektrisches Glied (28, 34 bzw. 29, 35) eingeschaltet ist, das jeweils aus einem Kondensator (28 bzw. 29) und einer Diode (34 bzw. 35) gebildet ist.

## Claims

1. Apparatus for coating a substrate (7), in particular with non-conducting layers, from electrically conductive targets (3, 4) in reactive (eg, oxidising) atmosphere, with a source of current (12, 13, 14, 27) connected to cathodes (1, 2) which are arranged in a coating chamber (15) that is capable of being evacuated and which include magnets and which interact electrically with the targets (3, 4), which are sputtered and the particles of which that have been detached by sputtering are deposited on the substrate (7), whereby anodes (5, 6) are provided which are electrically separated from one another and from the sputtering chamber (15) and which are arranged in a plane between the cathodes (1, 2) and the substrate (7), whereby the source of current exhibits a medium-frequency generator (13), a transformer (12) and a choke coil (14; 27) and the medium-frequency voltage is chosen to be so low that the plasma discharge is extinguished with each passage through zero of the AC voltage and ignites again in each half-wave of the AC voltage as soon as the voltage of the transformer has risen sufficiently, to which end the outputs (12a, 12b) of the secondary winding of a transformer (12) connected to a medium-frequency generator (13) are each connected via supply lines (20, 21) to one of the cathodes (1, 2 respectively), whereby the supply lines (20, 21) are connected to one another via a branch line (22) into which an oscillating circuit is inserted and whereby each of the two supply lines (20, 21) is connected both to the coating chamber (15) via a first network (16 and 17 respectively) that adjusts the DC potential with respect to earth and also to the respective anode (5 and 6) via an appropriate second network (8 and 9 respectively).

2. Apparatus according to Claim 1, characterised in that each of the two supply lines (20, 21) is connected both to the coating chamber (15) via a first electrical element (30, 32 and 31, 33 respectively) that adjusts the DC potential with respect to earth and also to the respective anode (5 and 6) via an appropriate second electrical element (28, 34 and 29, 35 respectively) and to the coating chamber (15) via, respectively, a branch line (38 and 39) with inserted capacitor (36 and 37 respectively) and whereby a choke coil (27) is inserted into the section of the first supply line (20) connecting the oscillating circuit (18, 19) to the secondary connection (12a) of the transformer.

3. Apparatus according to Claim 2, characterised in that the first electrical elements that are inserted into the two branch lines which connect the supply lines (20, 21) to the coating chamber (15) are each formed from a resistor (32 and 33 respectively) and a diode (30 and 31 respectively), whereby into the branch lines (40, 41) connecting the supply line (20 and 21 respectively) to the anode (5 and 6 respectively) there is inserted, respectively, a second electrical element (28, 34 and 29, 35) which in each case is formed from a capacitor (28 and 29 respectively) and a diode (34 and 35 respectively).

## Revendications

1. Appareil pour revêtir un substrat (7), en particulier de couches non conductrices,. en provenance de cibles (3, 4) électriquement conductrices, en atmosphère réactive (par exemple oxydante), comportant une source de courant (12, 13, 14, 27) qui est reliée à des cathodes (1, 2) qui sont disposées dans une chambre de revêtement (15) pouvant être mise sous vide, enclosent les aimants et collaborent électriquement avec les cibles (3, 4) qui se pulvérisent et dont les particules pulvérisées qui se déposent le font sur le substrat (7), appareil dans lequel sont disposées des anodes (5, 6) qui sont électriquement séparées l'une de l'autre et de la chambre de pulvérisation (15) et sont prévues dans un plan situé entre les cathodes (1, 2) et le substrat (7), dans lequel la source de courant présente un générateur de moyenne fréquence (13), un transformateur (12) et une bobine d'arrêt (14 ; 27) et on choisit la tension de moyenne fréquence suffisamment basse pour qu'à chaque passage de la tension alternative par la valeur zéro, la décharge de plasma s'éteigne et se rallume à nouveau à chaque demi-onde de la tension alternative dès que la tension du transformateur a suffisamment crû, ce pour quoi les sorties (12a, 12b) du bobinage secondaire du transformateur (12) relié à un générateur de moyenne fréquence (13) sont, chacune, reliées, par l'intermédiaire de lignes d'alimentation (20, 21), à l'une des cathodes (1 ou 2), dans lequel les lignes d'alimentation (20, 21) sont reliées l'une à l'autre par l'intermédiaire d'une ligne de dérivation (22) sur laquelle est mis en circuit un circuit oscillant, et dans lequel chacune des deux lignes d'alimentation (20, 21) est reliée aussi bien, par l'intermédiaire d'un premier réseau (16 ou 17) qui prescrit le potentiel de tension continue par rapport à la terre, avec la chambre de revêtement (15) que, par l'intermédiaire d'un second réseau (8 ou 9) correspondant, avec l'anode respective (5 ou 6).

2. Appareil selon la revendication 1, caractérisé par le fait que chacune des deux lignes d'alimentation (20, 21) est reliée, aussi bien, par l'intermédiaire d'un premier sous-ensemble électrique (30, 32 ou 31, 33) qui prescrit le potentiel de tension continue par rapport à la terre, avec la chambre de revêtement (15) que, par l'intermédiaire d'un second sous-ensemble électrique (28, 34 ou 29, 35) correspondant, avec l'anode respective (5 ou 6) et, par l'intermédiaire de, pour chacune, une ligne de dérivation (38 ou 39) sur laquelle est monté un condensateur (36 ou 37), avec la chambre de revêtement (15) et dans lequel une bobine d'arrêt (27) est mise en circuit sur le tronçon de la première ligne d'alimentation (20) qui relie le circuit oscillant (18, 19) avec la borne (12a) du secondaire du transformateur.

3. Appareil selon la revendication 2, caractérisé par le fait que les premiers sous-ensembles électriques mis en circuit sur les deux lignes de dérivation qui relient les lignes d'alimentation (20, 31) avec la chambre de revêtement (15) sont chacun formés d'une résistance (32 ou 33) et d'une diode (30 ou 31), étant précisé que sur chacune des lignes de dérivation (40, 41) qui relient la ligne d'alimentation (20 ou 21) avec l'anode (5 ou 6), est mis en circuit un second sous-ensemble électrique (28, 34 ou 29, 35) qui est chaque fois formé d'un condensateur (28 ou 29) et d'une diode (34 ou 35).
